# EUROPEAN PATENT APPLICATION

(11) **EP 0 908 921 A1**
(43) Date of publication of application: **14.04.1999**
(21) Application number: 97402395.4
(22) Date of filing: 10.10.1997
(51) Int. Cl.: H01J 37/32

(54) **Process chamber for plasma enhanced chemical vapour deposition and apparatus employing said process chamber**

(71) Applicant: EUROPEAN COMMUNITY, 2920 Luxembourg (LU)
(72) Inventor: Colpo, Pascal, 74960 Meythet (FR); Daviet, Jean-François, 74960 Cran-Gevrier (FR); Ernst, Roland, 38610 Gieres (FR); Rossi, François, 21021 Biandronno (IT)
(74) Representative: Joly, Jean-Jacques

(57) **Abstract**

The process chamber (2) for a plasma-enhanced chemical vapour deposition apparatus is of the type adapted to receive electromagnetic energy by inductive coupling from an external inductor (4) connected an ac supply (6), to enhance or sustain a plasma.

Inside the process chamber, there is provided a conductive means (16) arranged at a predetermined distance (d) from the internal surface of at least part of is enveloping wall portions such as to inhibit coating of vapour deposition material on this internal wall surface.

The conductive means can take the form of a conductive structure having an outer surface that follows an internal contour of at least part of the wall portions forming the process chamber. The conductive structure can comprise apertures (18) for facilitating the passage of electromagnetic energy into the process chamber.

## Description

The present invention relates to the field of plasma-assisted surface treatment using plasma enhanced chemical vapour deposition (PECVD) and, more particularly, to a process chamber for effecting PECVD. The invention also relates to a PECVD apparatus based on such a process chamber.

Chemical vapour deposition (CVD) in general is a technique for treating a surface of a workpiece, e.g. a substrate, by immersing the latter in a precursor gas or precursor gas mixture of selected materials within a process chamber. The materials in gaseous form, known as active species, can be deposited on the workpiece surface under controlled conditions (gas composition, pressure and temperature, and surface temperature, etc.). The composition of the immersing gas can also be chosen to etch away the surface of the workpiece at chosen areas using a mask.

Classical CVD generally requires the workpiece to be kept at a fairly high temperature to initiate and sustain the deposition of a film thereon, being essentially a thermally-driven process. It works satisfactorily (ignoring some more specific issues such as thermal stress) all the while the substrate can withstand the temperature that makes the process economically viable.

When this condition cannot be met, it is usual to overcome the temperature limitation by resorting to PECVD, which involves creating a plasma inside the process chamber to enhance vapour deposition (this technique is also known as plasma-assisted chemical vapour deposition (PACVD)).

The species generated by a plasma are characteristically different from those contained merely in the gas phase of the same precursor species used in classical chemical vapour deposition. This can be explained by the fact that plasma is intrinsically a medium in thermodynamic non-equilibrium. Although the actual phenomena that occur in a plasma are extremely complex, it can be said that, in general, the purely thermal activation of a classical CVD reaction generated by a high substrate temperature can be switched to the plasma phase in which the active species are pre-cracked in the plasma instead of being cracked only at the level of the hot substrate surface. Consequently, plasma-enhanced CVD allows a dramatically lower substrate temperature than with CVD for comparable film deposition characteristics.

PECVD is nowadays used extensively in surface engineering, such as surface passivation, cleaning, etching or deposition of various materials. It offers levels of performance unattainable by the other, more classical techniques.

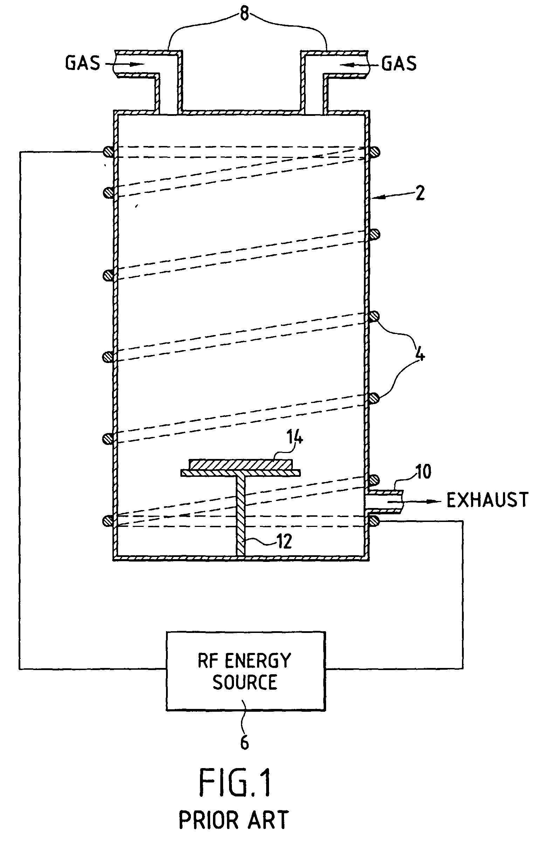

Figure 1 illustrates very schematically the main parts of a classical PECVD apparatus in which a plasma in generated by inductive coupling, currently the most versatile and reliable method of plasma generation for industrial applications.

The apparatus comprises a cylindrical reaction vessel 2 made of dielectric material, such as a quartz, surrounded by a radio-frequency (RF) inductor in the form of a helical electrode 4 connected to an RF energy source 6. When activated, the electrode 4 induces an RF electromagnetic energy field inside the reaction vessel 2 such as to create a plasma with the precursor gases by RF coupling.

In order to establish the gas conditions, the vessel 2 comprises a number of inlets 8 for controllably admitting the precursor gas or gases. It is also has an outlet 10 connected to an exhaust pump (not shown) to establish the required low pressure conditions and to evacuate used reaction gases.

A stage 12 having a T-shaped cross-section is provided in the vessel 2 for supporting a workpiece 14 at an optimum position within the plasma.

For the sake of simplicity, the means for accessing the chamber and handling the workpiece are not shown nor discussed, these being well-known in the art.

In operation, a workpiece 14 - which can be an insulator, semiconductor or conductor - is introduced onto the stage 12. The vessel 2 is then evacuated to a pressure corresponding to a partial vacuum, and a precursor gas or gas mixture is introduced through the inlets 8. The precursor gas used contains atoms or molecules of the material to be deposited in a form that can be liberated by the plasma in the process chamber 2, and is often admixed with deposition-enhancing components. The deposited material can be insulating or electrically conductive.

The RF energy source 6 is activated so as to induce a plasma of appropriate characteristics within the vessel. The plasma in the chamber breaks down the gas into its precursor species, which are then deposited in a controlled manner on the surface of the workpiece to form a layer of material corresponding to the precursor.

A problem arises with this type of apparatus when used for depositing layers of electrically conductive material. In this case, some of the atoms or molecules of the precursor gas containing the conductive material tend to migrate to the internal surface of the chamber walls and, over time, form a conductive film thereon. The conductive film tends to screen out the electromagnetic energy delivered by the RF inductor electrode 4. This phenomenon subsequently makes it impossible to sustain a plasma inside the process chamber, the electromagnetic energy being absorbed by the electrically conductive film instead of the plasma itself. The industrial consequence is a drift in the process performance and frequent downtime for cleaning the chamber walls.

To overcome this problem, some forms of PECVD apparatus have the inductor electrode contained inside the process chamber itself, so that the inner surface of the chamber walls is outside the RF energy field and hence outside the space occupied by the plasma.

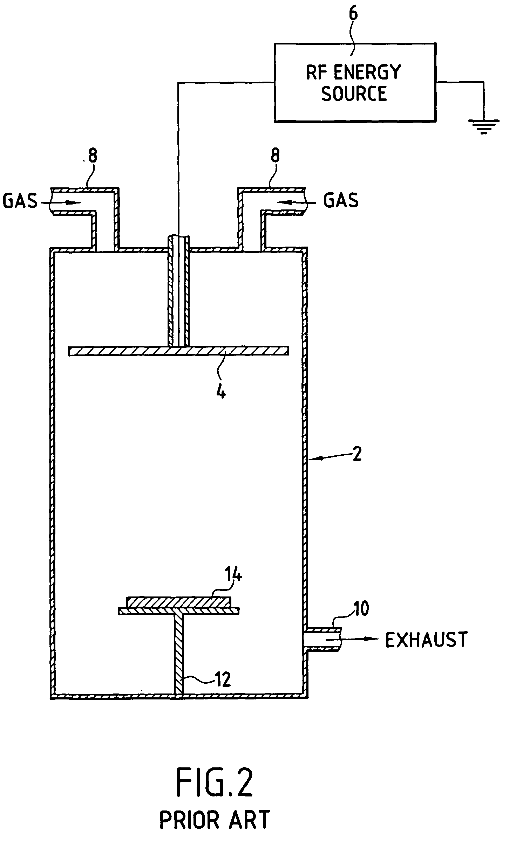

Such an apparatus is illustrated very schematically in figure 2, where elements corresponding to those of figure 1 are identified by like references and shall not be discussed further in any detail. The RF inductor electrode 4 has a plate-like structure and is installed inside the process chamber 2 above the stage 12. The latter can be isolated or biased to establish and maintain the plasma.

An example of such an apparatus is disclosed in document EP-A-0 424 620.

However, this approach brings problems of its own, including:
- the material of the RF electrode, being immersed in the plasma and reaction gas environment - at least at the level of its exposed surface - becomes a source of uncontrollable contamination, notably through sputtering by high-energy particles in the plasma, and
- the RF electrode additionally generates a very high and uncontrolled electric field within the plasma, which can create non-uniformities over the deposition surface.

An object of the present invention is to overcome the problem of unwanted film deposition on the inner surface of the process chamber without resorting to provide the inductor electrode inside the chamber.

The process chamber envisaged by the invention is bounded by wall portions and adapted to receive electromagnetic energy by inductive coupling from an external inductor connected an ac supply, to enhance or sustain a plasma.

According to the invention, there is further provided inside the chamber conductive means arranged at a predetermined distance from the internal surface of at least part of the wall portions such as to inhibit coating of vapour deposition material on this internal surface.

The conductive means thus effectively constitutes a trap for condensing conductive material particles in the plasma before they can reach the inner surface of the wall portions.

Over time, the film of conductive material that would otherwise be formed on the inner wall portions of the process chamber accumulates instead on the conductive means. However, this accumulation is not detrimental since it forms on surfaces which are already electrically conductive.

In preferred embodiments of the invention, the conductive means comprise a conductive structure having an outer surface that follows an internal contour of at least part of the wall portions of the process chamber.

The outer surface of the conductive structure can be configured to follow a substantial proportion of the wall portions. In this case, it may comprise one or more apertures.

The presence of one or more apertures in the case where the conductive means constitutes, to some extent at least, a Faraday cage can produce two significant effects.

Firstly, the aperture(s) (e.g. in the form of slits) divide the conductive means into a plurality of sectors, each sector being a portion of contour of the conductive means. In the presence of the plasma-inducing electromagnetic field, these sectors serve as intermediate inductors in accordance with Lenz's law. Basically, the conductive means can be considered as being placed in an inductor having a current Iind flowing therethrough. The inductor generates a magnetic field in all the environing space, giving rise to flux variations in the conductive means. The conductive means tends to cancel these flux variations by creating its own induced currents.

This phenomenon takes place between the inductor and each sector of the conductive means forming a Faraday cage. Induced currents created within each sector themselves create currents that are induced into the plasma.

The presence of one or more apertures can prevent such induced currents from forming loops extending around the entire periphery of the conductive means, and which would otherwise tend to short-circuit the magnetic field.

Secondly, the aperture(s) help to enhance the passage of electromagnetic energy into the process chamber.

Because the conductive material particles accumulate on the conductive surface of the structure, the apertures remain clear even after prolonged use. There is thus no drift in the performance characteristics of the process chamber over time.

The apertures may be in the form a series of slits following an arbitrary pattern. They may also be configured in the form of a series elementary cut-outs that are imbricated, so that the apertures have a labyrinthine pattern. Such a pattern can be advantageous for preventing a direct view between the plasma and the vacuum chamber.

If the process chamber has a regular geometry and the RF electromagnetic energy is to be present homogeneously inside, the apertures are preferably distributed uniformly over the conductive means.

The predetermined distance of the conductive means from the internal surface can be determined from Paschen's law on the ionisation of gases. This distance is relatively small, optimum results usually being obtained with values between 0.25 to 10 mm. For many types of process chamber, the distance can be a value less than 1 mm.

It has been found that the effectiveness of the conductive means can be greatly enhanced if it is cooled, e.g. by a fluid flow.

To this end, the conductive means can comprise a conduit arrangement for allowing a flow of thermal fluid and connected to a cold source for ensuring cooling thereof.

Depending on operating conditions (plasma characteristics, precursor gases, etc.) the efficiency of the conductive means can also be improved if means are provided for electrically biasing them with an ac voltage (including an RF voltage) or a dc voltage (including ground).

In this case, the conductive means can be divided into two or more isolated sections, the biasing means being operative for biasing the sections separately.

The conductive means can further comprise a window portion to enhance plasma ignition.

The window can be associated with shutter means for adjusting the degree of opening of the window.

If needs be, the process chamber can comprise a workpiece-supporting stage which is connectable to a biasing source to bias a workpiece on the stage, either directly or via a temperature-controlled susceptor, with an ac voltage (including an RF voltage) or a dc voltage (including ground).

The process chamber can further comprise a sputtering target.

The present invention also concerns a plasma-enhanced chemical vapour deposition (PECVD) apparatus comprising:
- a process chamber based on the conductive means as precedingly defined,
- an electromagnetic energy inductor for delivering electromagnetic energy to the process chamber, and
- an energy source for driving the inductor.

Depending on the embodiments, the apparatus may also comprise biasing means for biasing the conductive means with an ac voltage (including an RF voltage) or a dc voltage (including ground).

These biasing means can comprise means for independently biasing the two or more isolated sections of the conductive means, if the latter is so configured.

Finally, the present invention also concerns the use of plasma-enhanced chemical vapour deposition (PECVD) apparatus as defined above for depositing a conductive film on a substrate, or for ion etching on a substrate.

The invention will be better understood from the following description of preferred embodiments, given strictly as non-limiting examples, with reference to the appended drawings in which:
- figure 1 is a highly simplified sectional view of a classical PECVD apparatus with RF coupling of the electromagnetic energy field through the process chamber;
- figure 2 is highly simplified sectional view of a prior art PECVD apparatus with the electromagnetic energy field generated within the process chamber;
- figure 3 is a simplified general view of a PECVD apparatus according to the present invention;
- figure 4a shows an aperture pattern for the conductive structure used in the apparatus of figure 3, according to a first variant of the invention;
- figure 4b shows an aperture pattern for the conductive structure used in the apparatus of figure 3, according to a second variant of the invention;
- figure 5 is a general view of the conductive structure of figure 3 equipped with a cooling system;
- figure 5a is a partial plan view of the conductive structure of figure 5 and its positioning with respect to the process chamber; and
- figure 6 is a general view of a variant of the conductive structure shown in figure 5.

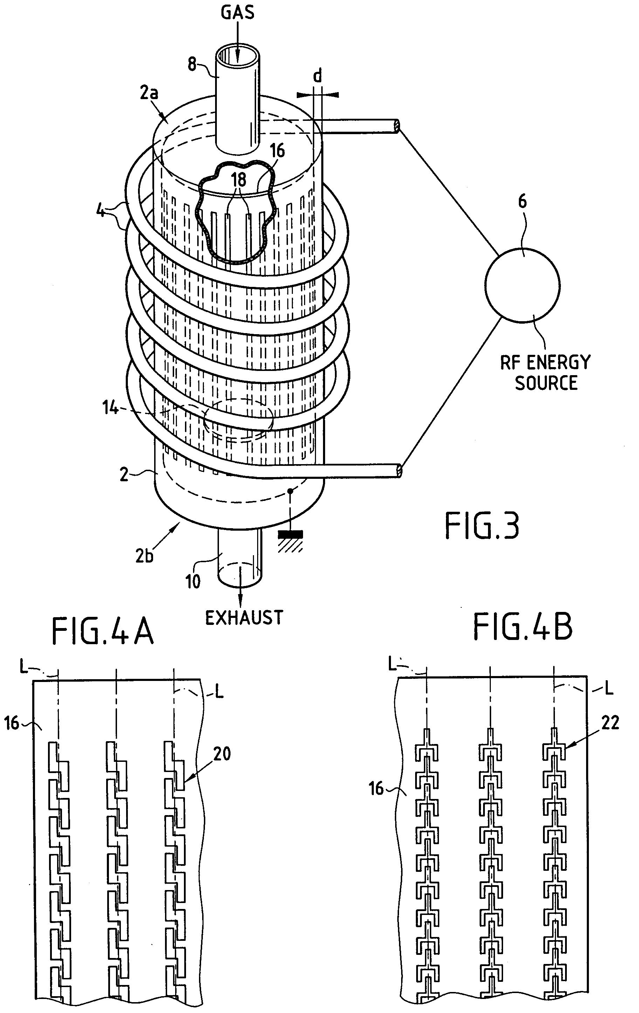

A PECVD apparatus in accordance with the present invention is shown in figure 3. For simplicity and conciseness, the parts of this apparatus which are analogous to those of figures 1 and 2 are given the same reference numerals and their functional role shall not be repeated.

In the example, the process chamber 2 is generally cylindrical, with its curved wall portion made of a dielectric material such as quartz. Because the dielectric material is transparent to the radio frequencies used, the electromagnetic energy generated by the RF energy source 6 is transmitted directly from the inductor electrode 4 through to the interior of the process chamber 2. In some other types of process chamber envisageable with the invention, the walls may be made largely of conductive material, in which case a dielectric window needs to be formed on one or several parts of the walls to allow adequate RF transmission from the inductor electrode 4 to the interior of the process chamber.

The top wall 2a and bottom wall 2b of the process chamber are made of stainless steel, and respectively include a reaction gas inlet 8 and an exhaust outlet 10.

The process chamber 2 also comprises means for maintaining a workpiece 14 inside the plasma environment. In the example, the workpiece 14 (e.g. a substrate) is held in suspension at a central position of the process chamber, e.g. by cables (not shown). Alternatively, the process chamber can be provided with a stage, as shown in the examples of figures 1 and 2, or any other known supporting structure.

If the process chamber 2 has a stage, the latter can be connected to a biasing source (not shown) to bias the workpiece (e.g. a substrate), either directly or via a temperature-controlled susceptor. For biasing, an ac voltage (including an RF voltage) or a dc voltage (including ground) may be used.

According to the invention, the process chamber 2 contains an electrically conductive structure 16. Its purpose is to inhibit the deposition of conductive vapour deposition material on the inner surface of the walls of the process chamber 2.

The conductive structure 16 is generally cylindrically shaped and positioned close to and concentrically with the cylindrical chamber wall. It is made from sheet metal, such as copper, having sufficient thickness to ensure minimal distortion under its own weight and over the temperatures existing inside the process chamber 2.

The radial separation d between the inner surface of the chamber wall and the outer surface of the conductive structure 16 is chosen such that no plasma is created between these two surfaces. The appropriate value of this separation d can be determined analytically using Paschen's law of ionisation in gases, or empirically. This value is a function of the chamber geometry, design of the conductive structure, frequency and intensity of the RF energy, as well as gas composition and pressure.

In the example based on a cylindrical, quartz process chamber operating at a pressure on the order of 100 milli Torr (converted as 13.3 Pa/m²), it has been found that excellent results can be obtained for a large variety of gases with the separation d kept to 1mm or less.

The conductive structure 16 can be held in position within the process chamber 2 by any suitable means. In order to ensure that the separation d is maintained accurately with respect to the cylindrical chamber 2, the inner wall of the latter can be provided with a series of ribs (not shown) projecting inwardly by an amount corresponding to the separation d. The outer surface of the conductive structure 16 is then held in abutment against the ribs, either by elasticity of its constituent material, or by mechanical mounts, adhesives or the like. The fixing of the conductive structure 16 inside the process chamber 2 may not necessarily be permanent. It is possible to make the conductive structure detachable from the process chamber to allow easy access both to the chamber itself, e.g. for insertion/removal of workpieces and to the conductive structure, e.g. for cleaning.

In order to allow adequate transmission of the RF energy into the process chamber 2, the conductive structure 16 is provided with a series of apertures formed uniformly over its surface. In the example of figure 3, the apertures are in the form of slits 18 that extend parallel to the principal axis of the conductive structure 16. The slit can of course be arranged to extend along other directions, e.g. obliquely with respect to the main axis of the process chamber. They can be continuous or divided into length segments over their path. The latter possibility can be chosen if required to make the conductive structure more rigid. In the example, the area occupied by the apertures corresponds to around e.g. 5 to 35 % of the total surface of the conductive structure. However, these values are only indicative; the area occupied by the apertures and their configuration can be adapted to design criteria for suitably diminishing losses and induced currents as explained above.

Figures 4a and 4b respectively show details of two other examples of configurations of apertures for the conductive structure 16. The apertures in both examples comprise sequences of identical elementary cut-outs that define a broken pattern. In this way, the conductive structure prevents a direct view to an entire axial portion of the chamber 2 for the RF energy delivered by the inductor electrode 4.

In figure 4a, each elementary cut-out 20 has a contour corresponding to two identical rectangles contiguous at their major sides but staggered with respect to each other. The stagger is equal to half the length the major side of the rectangle. The elementary cut-outs 20 are disposed along lines L according to an imbricated pattern whilst being separated from each other. The lines L can follow the direction of the slits 18 in figure 3, and be equally distributed over the surface of the conductive structure 16.

In figure 4b, each elementary cut-out has the shape of a two-pronged fork 22. The cut-outs 22 are also disposed along lines L, corresponding to those of figure 4a, according to an imbricated pattern whilst being separated from each other.

The conductive structure 16 is shown to be electrically grounded in the PECVD apparatus of figure 3.

However, it is also envisageable to provide means for biasing the conductive structure 16 with an ac voltage (including an RF voltage) or a dc voltage. In this case, the conductive structure can be divided into two or more isolated sections, each receiving an independent bias voltage from a respective biasing source.

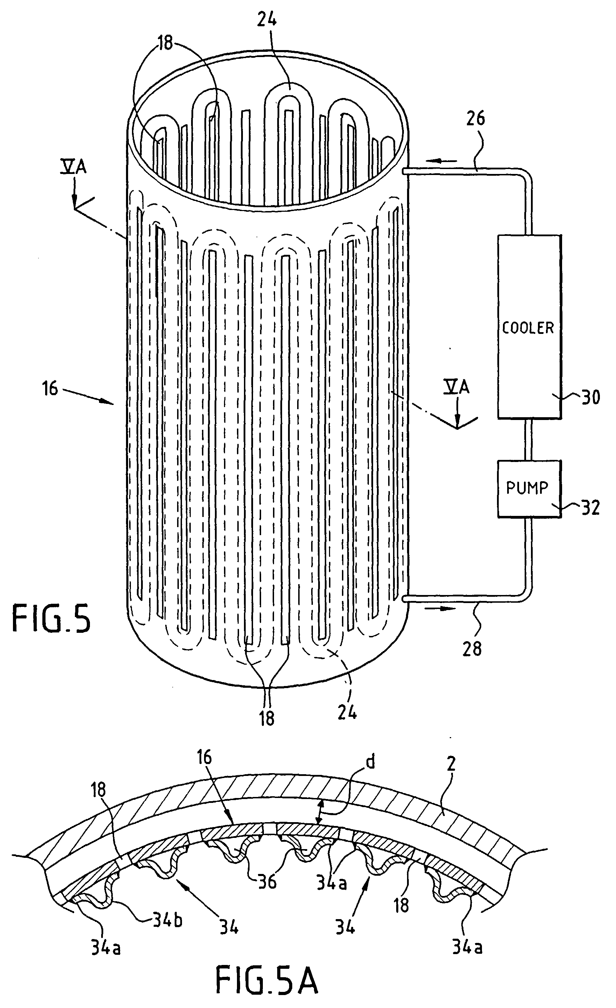

Figure 5 shows the conductive structure 16 implemented in the apparatus of figure 3, additionally provided with a cooling arrangement. The cooling arrangement comprises fluid conduits 24 incorporated into the conductive structure 16 and communicating through an inlet 26 and an outlet 28 with a fluid cooler 30 and a pump 32 in a closed system. The cooling fluid used can be water, possibly with some additives, oil or any other liquid. Cooling may also be effected by forced air passing through the conduits 24.

The incorporation of the fluid conduits 24 into the conductive structure 16 is shown in more detail in figure 5a. The fluid conduits 24 are formed by narrow, profiled metal strips 34 that run along a substantial portion of the axial length of the conductive structure 16. In the example, there is provided a conduit 34 between each pair of slits 18. The strips have a tab portion 34a at each longitudinal edge and an arcuate portion 34b between the tab portions. The tab portions 34a are sealingly attached, e.g. by welding, to the inner surface of the conductive structure at a region between the slits 18 and parallel to the latter. The arcuate portion 34b of the strip creates a channel 36 with the confronting inner surface of the conductive structure 16, allowing passage of the cooling fluid.

The metal strips 34 are interconnected at end portions of the conductive structure so that their respective channels form a continuous serpentine conduit configuration between the fluid inlet 26 and outlet 28.

It can be noted that with this construction, the cooling system forms an integral part of the conductive structure, being in direct physical contact with the cooling fluid. The heat generated at the structure is thereby evacuated very efficiently. Moreover, the strips 34 create negligible shadowing of the apertures (in this case formed by the slits 18).

The above-described conduits can of course be implemented with a conductive structure having apertures of the type described with reference to figures 4a and 4b, or indeed any other type of aperture configuration.

Alternatively, the conduits can be implemented by an arrangement of pipes and radiator fins attached to the conductive structure in accordance with standard practices for heat sinks.

It has been found by the applicant that by maintaining the conductive structure cool, the deposition rate of conductive material onto its inner surface is reduced dramatically.

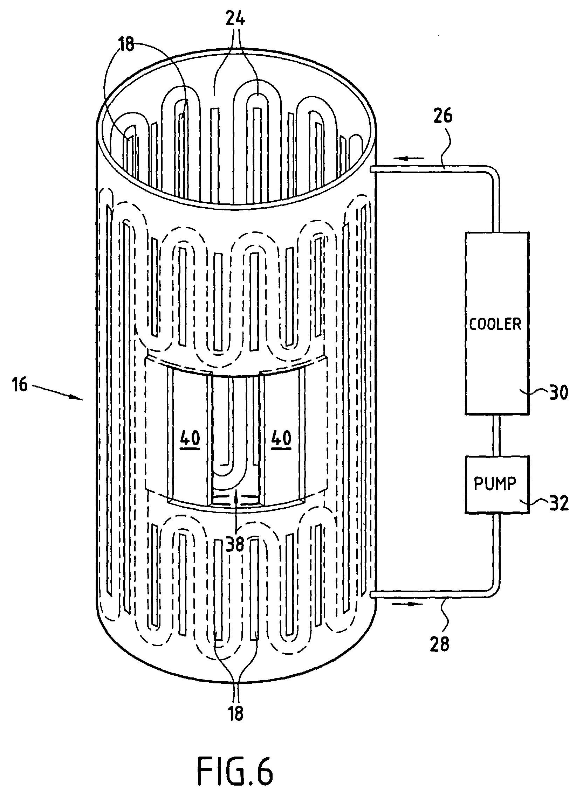

Figure 6 shows a variant of the conductive structure described with reference to figure 5 that features an adjustable window to help establish plasma electrostatic ignition.

The window 38 comprises a cut-out portion of the conductive structure 16 located e.g. mid-way between the ends of the latter and occupying e.g. 10 to 25% of its circumference. The window area is selectively adjustable between open and closed states by means of a pair slidable conductive shutters 40. The shutters 40 follow the contour of the conductive structure 16 and are mounted on the inner face of the latter so as leave the free the small separation d between the outer face of the conductive structure and the inner face of the reaction chamber wall. Each shutter 40 is slidable, either manually or by a remote control mechanism (not shown) in a circumferential direction to close a selected portion of the window cut-out 38.

The apertures in conductive structure 16, whether they be slits 18 or elementary cut-outs 20 or 22 stop short of the boundaries of the window area 38 to allow the passage and interconnection of the cooling conduits 24 around that area.

Although only one window cut-out 38 is shown in the figure, it can be envisaged to provide several windows for the same purpose. The windows may be distributed around the circumference of the conductive structure and/or superposed along the principal axis of the latter.

It should be noted that the conductive structure in all of the embodiments described can be further provided with additional apertures for allowing access to the process chamber.

The present invention can be implemented in many other forms than those just described.

For instance, the process chamber need not be cylindrical, but can have any appropriate shape according to applications and design practice. The shape of the conductive structure will then be adapted correspondingly.

While the problem of unwanted coating of a conductive film on the inner face of the process chamber occurs essentially when the chamber is used with reaction gases containing conductive materials for depositing on a workpiece, the present invention can of course also be used in PECVD apparatus for all types of surface processing, such as for deposition of insulating and semiconducting materials or for etching.

## Claims

1. A process chamber (2) for a plasma-enhanced chemical vapour deposition apparatus, said chamber being bounded by wall portions and adapted to receive electromagnetic energy by inductive coupling from an external inductor (4) connected an ac supply (6), to enhance or sustain a plasma,
characterised in that said chamber further comprises therewithin conductive means (16) arranged at a predetermined distance (d) from the internal surface of at least part of said wall portions such as to inhibit coating of vapour deposition material on said internal surface.

2. The process chamber (2) according to claim 1, wherein said conductive means (16) comprises a conductive structure having an outer surface that follows an internal contour of at least part of said wall portions.

3. The process chamber (2) according to claim 2, wherein said outer surface follows a substantial proportion of said wall portions and comprises at least one aperture (18; 20; 22) for allowing the passage of electromagnetic energy into said process chamber.

4. The process chamber (2) according to claim 3, wherein said apertures form a series of slits (18).

5. The process chamber (2) according to claim 3, wherein said apertures comprise elementary cut-outs (20; 22) that form an imbricated pattern.

6. The process chamber (2) according to any one of claims 3 to 5, wherein said apertures(s) (18; 20; 22) are arranged so as to break down circulating currents induced in said conductive means (16) into plural current loops.

7. The process chamber (2) according to any one of claims 3 to 6, wherein said apertures (18; 20; 22) are distributed uniformly over said conductive means (16).

8. The process chamber (2) according to any one of claims 1 to 7, wherein said predetermined distance (d) from the internal surface is between 0.25 to 10 mm.

9. The process chamber (2) according to any one of claims 1 to 7, wherein said predetermined distance (d) from the internal surface is less than 1 mm.

10. The process chamber (2) according to any one of claims 1 to 9, wherein said conductive means (16) are cooled by a fluid flow.

11. The process chamber (2) according to claim 10, wherein said conductive means (16) comprise conduit means (24) for allowing a flow of thermal fluid, connected to a cold source (30) for ensuring cooling thereof.

12. The process chamber (2) according to any one of claims 1 to 11, further comprising biasing means for electrically biasing said conductive means (16) with an ac voltage (including an RF voltage) or a dc voltage (including ground).

13. The process chamber (2) according to claim 12, wherein said conductive means (16) are divided into two or more isolated sections, said biasing means being operative for biasing said sections separately.

14. The process chamber (2) according to any one of claims 1 to 13, wherein said conductive means (16) further comprise at least one window portion (38) to enhance plasma ignition.

15. The process chamber (2) according to claim 14, further comprising shutter means (40) for adjusting the degree of opening of said window (38).

16. The process chamber (2) according to any one of claims 1 to 15, further comprising a workpiece-supporting stage which is connectable to a biasing source to bias a workpiece on said stage, either directly or via a temperature-controlled susceptor, with an ac voltage (including an RF voltage) or a dc voltage (including ground).

17. The process chamber (2) according to any one of claims 1 to 16, further comprising a sputtering target.

18. A plasma-enhanced chemical vapour deposition (PECVD) apparatus comprising:
a process chamber according to any one of the preceding claims,
an electromagnetic energy inductor (4) external of said process chamber for delivering electromagnetic energy thereto, and
an energy source (6) for driving said inductor.

19. The plasma-enhanced chemical vapour deposition (PECVD) apparatus according to claim 18, further comprising biasing means for biasing the conductive means (16) of the process chamber (2) with an ac voltage (including an RF voltage) or a dc voltage (including ground).

20. The plasma-enhanced chemical vapour deposition apparatus according to claim 19, wherein said biasing means comprise means for independently biasing two or more isolated sections of the conductive means (16) of the process chamber (2).

21. Use of plasma-enhanced chemical vapour deposition (PECVD) apparatus according to any one of claims 18 to 20 for depositing a conductive film on a substrate.

22. Use of a plasma-enhanced chemical vapour deposition (PECVD) apparatus according to any one of claims 18 to 20 for ion etching on a substrate.
